# EUROPÄISCHE PATENTSCHRIFT

(11) **EP 1 058 379 B1**
(45) Veröffentlichungstag und Bekanntmachung des Hinweises auf die Patenterteilung: **08.09.2010**
(21) Anmeldenummer: 00109778.1
(22) Anmeldetag: 09.05.2000
(51) Int. Cl.: H03D 7/14

(54) **Gegentaktanordnung**
Push pull device
Dispositif équilibré

(30) Priorität: 31.05.1999 DE 19924716
(43) Veröffentlichungstag der Anmeldung: 06.12.2000
(73) Patentinhaber: EADS Deutschland GmbH, 81663 München (DE)
(72) Erfinder: Nüchter, Peter, 89079 Ulm (DE)
(74) Vertreter: Meel, Thomas

(56) Entgegenhaltungen:
- WO-A-97/41644
- WO-A-99/18661
- US-A- 4 992 761
- TZU-HUNG CHEN ET AL: "A Q-BAND MONOLITHIC BALANCED RESISTIVE HEMT MIXER USING CPW/SLOTLINE BALUN" IEEE JOURNAL OF SOLID-STATE CIRCUITS, IEEE INC. NEW YORK, US, Bd. 26, Nr. 10, 1. Oktober 1991 (1991-10-01), Seiten 1389-1394, XP000264303 ISSN: 0018-9200

## Beschreibung

Die Anmeldung bezieht sich auf einen Gegentaktanordnung für den Einsatz in Frequenzvervielfachern, Empfangsmischern, Signalumsetzern oder Modulatoren die nach dem Gegentaktprinzip arbeiten und die mit der Grundwelle oder einer subharmonischen des Überlagerungs-/Lokaloszillators ausgesteuert werden, nach dem Oberbegriff des Patentanspruches 1.

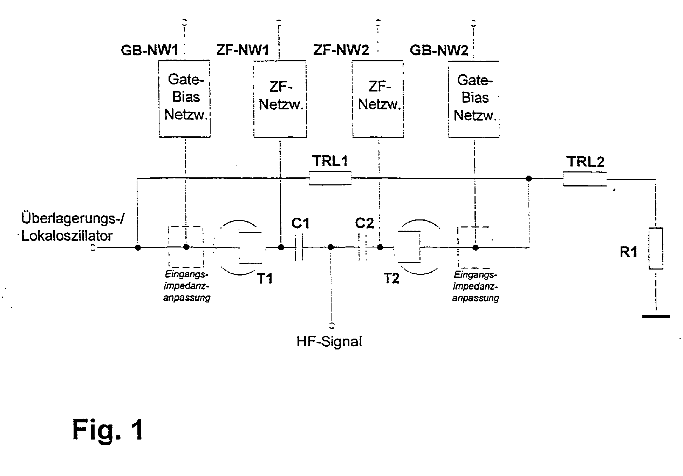

Das Prinzip der Gegentaktaussteuerung bei Transistormischem ist sowohl bei subharmonischer als auch bei Grundwellenbetriebsart bekannt (vgl. Fig.9.13, S.335 und Fig. 9.16, S.341 aus 'Steven A. Maas, Microwave Mixers, 2. Ausgabe, Artech House, 1993 sowie Fig. 1-3 aus WO 97/41644 A). Bei den vorbekannten Lösungen wird die Leistung des Überlagerungs-/Lokaloszillators durch einfache Umwegleitungen oder durch 180°-Hybride auf die Gateanschlüsse der Feldeffekttransistoren FET (alternativ: Basisanschlüsse im Falle von Bipolartransistoren) geführt. Durch unvermeidliche Exemplarstreuungen stellen die Transistoren ungleiche Abschlüsse für diese Aussteuersignale dar, was zu unterschiedlichen Reflexionen und damit zu ungleicher Leistungsaufteilung und unerwünschten Phasenlagen führt. Diese Problematik kann durch teilweise Voranpassung der Transistoren nicht grundlegend oder nur unter Inkaufnahme erheblicher Leistungsverluste verbessert werden.

Aufgabe der Erfindung ist es, mit möglichst geringem Bauteileaufwand die Leistung des Signals vom Überlagerungs-/Lokaloszillators so aufzuteilen, daß die Transistoren mit gleicher Leistung und 180° Phasenverschiebung zueinander ausgesteuert werden, und daß das Signal trotz Exemplarstreuung der Transistorparameter gut von den weiteren Signaltoren der Schaltung entkoppelt ist.

Die erfindungsgemäße Lösung der Aufgabe besteht darin, daß, ähnlich wie bei einem Wanderwellenverstärker (hier jedoch reduziert auf zwei Transistoren), der Wellenwiderstand der Umwegleitung, bzw. bei größerer Bandbreitenanforderungen der Wellenwiderstand eines ein- oder mehrstufigen Hybrids, passend zu den Transistor-Eingangswiderständen gewählt wird. zusätzlich wird ein Abschlußwiderstand am zweiten Transistor vorgesehen, der entweder unmittelbar oder mit einer Leitung mit passendem Wellenwiderstand angeschlossen ist. Unterstützend dazu kann eine Voranpassung der Transistoreingangsimpendanzen vorgenommen werden.

Der Vorteil der Erfindung besteht darin, daß sich Exemplarstreuungen nicht mehr unmittelbar in starken Anpassungsänderungen innerhalb einer Resonanzstruktur auswirken, sondern, innerhalb eines gewissen Bereichs der Exemplarstreuungen, hauptsächlich eine leichte Veränderung der Phasenlage der Aussteuersignale bewirken. Eine weitere vorteilhafte Ausgestaltung der Erfindung ergibt sich für den Fall, daß die Steuereingänge der Transistoren **T1** und **T2** mittels einer Schaltung zur Eingangsimpedanzanpassung versehen werden. Hierdurch wird eine zusätzliche Kompensation etwaiger Exemplarstreuungen der Transistoren **T1** und **T2** zielt.

Das Ausführungsbeispiel in Figur 1 zeigt ein schematisches Schaltbild einer erfindungsgemäßen Gegentaktanordnung. Entsprechend der herkömmlichen Realisierung eines Gegentaktanordnung sind die Feldeffekttransistoren **T1** und **T2** an Gate-Bias-Netzwerke **GB-NW1** und **GB-NW2** sowie an Zwischenfrequenz-Netzwerke **ZF-NW1** und **ZF-NW2** gekoppelt. Das HF-Signal an den Transistoren **T1** und **T2** (an deren Ausgängen bzw. an deren Eingängen, entsprechend dem Betriebsfall) wird über Koppelkondensatoren **C1** und **C2** gekoppelt. Um von Exemplarstreuungen der beiden Transistoren **T1** und **T2** herrührende Anpassungsänderungen innerhalb der Resonanzstruktur zu vermeiden, werden die Steuereingänge der Transistoren **T1** und **T2** nicht nur über eine 180°-Verzögerungsleitung, bzw. bei größerer Bandbreitenanforderungen einem ein- oder mehrstufigen Hybrid, **TRL1** miteinander verbunden, sondern es wird zusätzlich am zweiten Transistor **T2** ein Abschlußwiderstand **R1** vorgesehen, der entweder unmittelbar oder über eine Abschlußleitung **TRL2** mit passendem Wellenwiderstand angeschlossen wird. Die Bauteile **TRL1**, **TRL2** und **R1** sind dahingehend zu dimensionieren (z.B. durch Simulation), daß die beiden Transistoren **T1** und **T2** gegenphasig mit gleicher Signalamplitude angesteuert werden. Dabei ist darauf zu achten, daß folgende beiden Bedingungen erfüllt sind:
1. Wellenwiderstandsbedingung: Z_{TRL1} ≈ Z_{TRL2}=R1,
   wobei Z_{TRLx} die Wellenwiderstände der Leitungen **TRL1** und **TRL2** sind. Dabei ist zu beachten, daß in der Praxis Z_{TRL1} und Z_{TRL2} im allgemeinen nicht genau gleich sind, da auf Grund von Verzweigungen und speziellen Geometrien innerhalb des Schaltungslayouts zu Impedanzverschiebungen kommen kann.
2. Phasenbedingung: φ_{TRL1} ≈ 180°
   wobei φ_{TRL1} der Phasenverschiebung zwischen den Steuereingängen der beiden Transistoren **T1** und **T2** entspricht. Hierbei ist bei Dimensionierung von **TRL1** jedoch auch u.a. die Transistor Eingangsimpedanz und die Leitungsgeometrie zwischen den Transistoren und **TRL1** zu beachten.

Das oben beschriebene Ausführungsbeispiel bezieht sich zwar auf die Realisierung der erfindungsgemäßen Gegentaktanordnung mit Feldeffekttransistoren, es ist aber selbstverständlich auch denkbar auf entsprechende Weise eine Gegentaktanordnung mit anderen Typen von Transistoren (z.B.: Bipolartransistoren) zu realisieren.

## Patentansprüche

1. Gegentaktanordnung umfassend
- einen Überlagerungs-/Lokaloszillator,
- einen ersten Transistor (T1) und einen zweiten Transistor (T2), wobei die Leistung des Signals des Überlagerungs-/Lokaloszillators so aufgeteilt wird, daß er erste und zweite Transistor (T1, T2) mit gleicher Leistung und 180° phasenverschoben ausgesteuert wird
**dadurch gekennzeichnet, daß**
- ein Abschlusswiderstand (R1) vorgesehen ist, welcher mit dem Steuereingang des zweiten Transistor (T2) verbunden ist,
- ein ein- oder mehrstufigen Hybrid (TRL1) vorgesehen ist, welcher die Steuereingänge des ersten und zweiten Transistors (T1, T2) verbindet und einen Wellenwiderstand Z_{TRL1} aufweist, welcher an das Schaltungslayout und die Eingangsimpedanzen des ersten und zweiten Transistors (T1, T2) angepasst ist,
- wobei der Steuereingang des zweiten Transistor (T2) mit dem Abschlusswiderstand (R1) über eine Abschlussleitung (TRL2) verbunden ist, wobei die Abschlussleitung (TRL2) einen Wellenwiderstand Z_{TRL2} aufweist, welche dem Wellenwiderstand Z_{TRL1} des ein- oder mehrstufigen Hybrid (TRL1) entspricht.

2. Gegentaktanordnung nach Anspruch 1, **dadurch gekennzeichnet, daß** die Steuereingänge der Transistoren mit einer Schaltung zur Eingangsimpedanzanpassung versehen sind.

## Claims

1. Push-pull arrangement comprising:
- a heterodyne local oscillator,
- a first transistor (T1) and a second transistor (T2), wherein the power of the signal of the heterodyne local oscillator is split such that the first and second transistors (T1, T2) are driven with the same power but with a phase shift of 180°,
**characterized in that**
- a terminating resistor (R1) is provided and is connected to the control input of the second transistor (T2),
- a single-stage or multistage hybrid (TRL1) is provided, which connects the control inputs of the first and second transistors (T1, T2) and has a characteristic impedance Z_{TRL1} which is matched to the circuit layout and the input impedances of the first and second transistors (T1, T2),
- wherein the control input of the second transistor (T2) is connected to the terminating resistor (R1) via a terminating line (TRL2), wherein the terminating line (TRL2) has a characteristic impedance Z_{TRL2} which corresponds to the characteristic impedance Z_{TRL1} of the single-stage or multistage hybrid (TRL1).

2. Push-pull arrangement according to Claim 1, **characterized in that** the control inputs of the transistors are provided with a circuit for input impedance matching.

## Revendications

1. Arrangement push-pull, comprenant
- un oscillateur hétérodyne/local,
- un premier transistor (T1) et un deuxième transistor (T2), la puissance du signal de l'oscillateur hétérodyne/local étant distribuée de telle sorte que le premier et le deuxième transistors (T1, T2) sont commandés avec la même puissance et un déphasage de 180°
**caractérisé en ce que**
- il est prévu une résistance de terminaison (R1) qui est reliée avec l'entrée de commande du deuxième transistor (T2),
- il est prévu un circuit hybride (TRL1) à un ou plusieurs étages qui relie les entrées de commande du premier et du deuxième transistors (T1, T2) et présente une impédance caractéristique Z_{TRL1} qui est adaptée à l'implantation du circuit et aux impédances d'entrée du premier et du deuxième transistors (T1, T2),
- l'entrée de commande du deuxième transistor (T2) étant reliée avec la résistance de terminaison (R1) par le biais d'une ligne de terminaison (TRL2), la ligne de terminaison (TRL2) présentant une impédance caractéristique Z_{TRL2} qui correspond à l'impédance caractéristique Z_{TRL1} du circuit hybride (TRL1) à un ou plusieurs étages.

2. Arrangement push-pull selon la revendication 1, **caractérisé en ce que** les entrées de commande des transistors sont munies d'un circuit d'adaptation de l'impédance d'entrée.
